# EUROPEAN PATENT APPLICATION

(11) **EP 2 584 604 A1**
(43) Date of publication of application: **24.04.2013**
(21) Application number: 11795523.7
(22) Date of filing: 24.05.2011
(51) Int. Cl.: H01L 23/40, H01L 23/36, H05K 7/20

(54) **HEAT DISSIPATION STRUCTURE FOR ELECTRONIC DEVICE**

(30) Priority: 18.06.2010 JP 2010138940
(71) Applicant: Sharp Kabushiki Kaisha, Osaka-shi, Osaka 545-8522 (JP)
(72) Inventor: KURODA Tatsuro, Osaka-Shi, osaka 545-85221 (JP)
(74) Representative: Müller-Boré & Partner Patentanwälte
(86) International application number: PCT/JP2011/061819
(87) International publication number: WO 2011/158615

(57) **Abstract**

A heat dissipation structure in which an IC chip that generates heat is mounted on a substrate and a heat dissipation sheet is interposed between a cover member and the IC chip to dissipate heat, wherein chip-pressing parts (5) are provided to a cover member (4), so that IC chips (3) are pressed against heat dissipation sheets (1) by the chip-pressing parts (5), and each chip-pressing part (5) is configured from an elastic pressing part equipped with an elastically deformable elastic section (51), and a contact section (52) that comes into contact with a heat dissipation sheet (1), in order to provide an electronic device heat dissipation structure that exhibits sufficient heat dissipation properties and improves the reliability of the electronic device, and has a structure such that it is possible to reliably interpose a heat dissipation sheet between an IC chip and a cover member.

## Description

### Technical Field

The present invention relates to a heat dissipation structure for an electronic device, for use in liquid crystal display devices and the like.

### Background Art

Recent years have seen proliferation of electronic devices provided with circuit boards on which electronic components such as IC chips (semiconductor chips) are mounted. For example, circuit boards for driving liquid crystal display panels in liquid crystal display devices have many such electronic components mounted on them.

To cope with miniaturization of electronic devices, electronic components used in them are packed at increasing densities, and arranging electronic components such as IC chips densely in a small space poses a challenge of working out how to deal with the heat generated.

Electronic components such as IC chips mounted on a board, when subjected to a rise in temperature due to the heat they generate during use, may suffer variations in their characteristics, leading to malfunctioning of devices, or may fail themselves. To prevent that, there have conventionally been proposed various heat dissipation structures for suppressing a rise in the temperature of electronic components such as IC chips.

For example, according to one conventional proposal, dissipation of heat from an electronic components such as an IC chip is achieved by use of a heat dissipating plate. According to another, a rubber sheet having a heat conducting property is interposed between such a heat dissipating plate and an IC chip so that, via the rubber sheet, the heat of the IC chip is quickly transferred to the heat dissipating plate.

In a case where a plurality of IC chips are mounted on a single board, this means that a plurality of heat generating bodies come close together. In electronic devices with such designs, quicker dissipation of heat from the individual IC chips is required.

Inconveniently, however, in a case where different chips have different mounting heights due to their different thicknesses, rubber sheets and heat dissipating plates that suit the different chip heights need to be provided; that is, different heat dissipation structures need to be selected for different IC chips.

Thus, in practice, for each IC chip, the heat dissipating sheet is interposed directly to dissipate heat from each IC chip. For example, in a known heat dissipation structure for an electronic device, a silicone rubber sheet for heat dissipation is interposed between a heat generating body mounted on a board and a metal case so that the heat generated by the heat generating body is quickly transferred to the metal case so as to be rejected out of the device (see, for example, Patent Document 1 listed below).

In liquid crystal display devices incorporating a backlight that uses an LED (light emitting diode) as a light source, the LED chip itself acts as a heat generating body, and therefore it is preferable to quickly dissipate the heat generated by the LED chip. Accordingly, in a known liquid crystal display device, a metal case having a prominent heat dissipating property is attached in position via a fitting member so that the heat generated by the LED chip is efficiently rejected (see, for example, Patent Document 2 listed below).

### List of Citations

### Patent Literature

Patent Document 1: Japanese Patent Application Publication No. H10-308484
Patent Document 2: Japanese Patent Application Publication No. 2010-2745

### Summary of Invention

### Technical Problem

By interposing a heat dissipating sheet such as of silicone rubber having a good heat conducting property between a heat generating body such as an IC chip mounted on a board and a cover member which covers the board and also serves as a heat dissipating plate, it is possible to dissipate the heat generated by the heat generating body such as an IC chip via the cover member. Moreover, by using a heat dissipating sheet that is flexible, it is possible to cope with, to a certain extent, variation in the distance between the heat generating body such as an IC chip and the cover member.

In a case where a plurality of IC chips having varying heights are mounted on a single board, however, the distance between those IC chips and the board cover varies accordingly. Thus, the contact pressure between the IC chips and the heat dissipating sheet varies, and this inconveniently results in insufficient heat dissipation. It is therefore preferable to interpose a heat dissipating sheet with an adequate thickness that suits the distance.

Chip holding portions having a heat conducting property may be provided on the board cover so as to protrude from it so that a heat dissipating sheet having an even thickness can be interposed. In that case, beforehand, the chip holding portions are formed to have predetermined protrusion heights that suit the thicknesses of the IC chips to be mounted. Inconveniently, however, if fabrication errors occur, the protrusion heights deviate, resulting in the contact pressure varying from place to place.

Too low contact pressure lead to insufficient heat dissipation. This causes a rise in the temperature of an IC chip, and thus causes its characteristics to vary, leading to malfunctioning of the device. On the other hand, too high contact pressure causes the board to yield, or causes an electronic component itself to fail.

As described above, too low or high contact pressure between the heat dissipating sheet and the IC chip causes various inconveniences including diminished heat dissipation, leading to malfunctioning, and damage to the IC chip.

Thus, in a case where a plurality of IC chips are mounted on a board, even when they have varying mounting heights, it is preferable that the heat dissipating sheet be brought into contact with the entire surface of the IC chip to obtain a heat dissipation structure that reliably achieves heat dissipation.

In view of the inconveniences mentioned above, the present invention, directed to a heat dissipation structure in which an IC chip as a heat generating body is mounted on a board and a heat dissipating sheet is interposed between the IC chip and a cover member to achieve heat dissipation, aims to provide a heat dissipation structure for an electronic device that allows reliable interposition of the heat dissipating sheet between the IC chip and the cover member to achieve sufficient heat dissipation and that can thereby improve the reliability of the electronic device.

### Solution to Problem

To achieve the above object, according to the invention, a heat dissipation structure for an electronic device includes: an IC chip; a board on which the IC chip is mounted; a cover member which has a heat dissipating property and which covers the mounting face side of the board; and a heat dissipating sheet which is interposed between the IC chip and the cover member, the heat dissipating sheet dissipating heat of the IC chip. Here, the cover member includes a chip holding portion so that, via the chip holding portion, the heat dissipating sheet is pressed against the IC chip. Moreover, the chip holding portion includes: an elastic section which has one end thereof secured to the cover member so as to be elastically deformable in the direction away from the cover member; and a contact section which is connected to the other end of the elastic section and which makes contact with the heat dissipating sheet.

With this configuration, even when variation occurs in the distance between the IC chip and the cover member, it is possible to bring the heat dissipating sheet and the cover member into contact with each other, and thereby to obtain a heat dissipation structure for an electronic device that offers sufficient heat dissipation and can improve the reliability of the electronic device.

According to the invention, in the heat dissipation structure for an electronic device configured as described above, preferably, a heat dissipating plate is provided on the outer side of the cover member opposite from the side thereof on which the chip holding portion is provided. With this configuration, it is possible to further improve heat dissipation and obtain a heat dissipation structure for an electronic device that can further improve the reliability of the electronic device.

According to the invention, in the heat dissipation structure for an electronic device configured as described above, preferably, the chip holding portion is formed by cutting out part of the cover member, and the heat dissipating plate as a separate member is arranged around the opening where the chip holding portion is formed. With this configuration, it is possible to easily form the chip holding portion through sheet metal working of the cover member. Moreover, it is possible to achieve high heat dissipation by fitting a heat dissipating plate formed as a member having a prominent heat dissipating property.

According to the invention, in the heat dissipation structure for an electronic device configured as described above, preferably, the heat dissipating plate is formed by cutting out part of the cover member, and the chip holding portion as a separate member is arranged around the opening where the heat dissipating plate is formed. With this configuration, it is possible to easily form the heat dissipating plate by sheet metal working of the cover member. Moreover, by pressing the IC chip via a chip holding portion formed as a member having prominent elasticity, even when variation occurs in the distance between the IC chip and the cover member, it is possible to reliably bring them into pressed contact with each other, and thus it is possible to achieve the desired heat dissipation.

According to the invention, in the heat dissipation structure for an electronic device configured as described above, preferably, the chip holding portion and the heat dissipating plate are both formed as separate members, an opening is formed in the part of the cover member where the chip holding portion is arranged, and the chip holding portion and the heat dissipating plate are both arranged around the opening. With this configuration, by attaching a heat dissipating plate formed as a member having prominent heat dissipation and a chip holding portion formed as a member having prominent elasticity, it is possible to reliably interpose the heat dissipating sheet between the IC chip and the cover member, and to achieve the desired heat dissipation.

According to the invention, in the heat dissipation structure for an electronic device configured as described above, preferably, the chip holding portion has an open window through which whether the heat dissipating sheet is present or absent can be checked. With this configuration, it is possible to check whether or not the heat dissipating sheet is actually interposed, and it is thereby possible to obtain a heat dissipation structure for an electronic device that reliably offers the desired heat dissipation.

According to the invention, in the heat dissipation structure for an electronic device configured as described above, preferably, the chip holding portion includes a heat dissipating section. With this configuration, it is possible to promote heat dissipation via the heat dissipating section provided on the chip holding portion itself, and thereby to achieve stable heat dissipation performance.

According to the invention, in the heat dissipation structure for an electronic device configured as described above, preferably, the chip holding portion has a portion thereof making contact with the heat dissipating sheet formed as a sharp-ridged contact portion that protrudes in a sharp-ridged shape. With this configuration, by bringing the sharp-ridged contact portion into contact with the heat generating part of the IC chip, it is possible to reliably dissipate the heat of the IC chip via the heat dissipating sheet interposed, and it is thus possible to achieve sufficient heat dissipation and improve the reliability of the electronic device.

According to the invention, in the heat dissipation structure for an electronic device configured as described above, preferably, the chip holding portion has a portion thereof making contact with the heat dissipating sheet formed as a round-ridged contact portion that protrudes in a round-ridged shape. With this configuration, by bringing the round-ridged contact portion into contact with the heat generating part of the IC chip, it is possible to reliably dissipate the heat of the IC chip via the heat dissipating sheet interposed, and it is thus possible to achieve sufficient heat dissipation and improve the reliability of the electronic device.

According to the invention, in the heat dissipation structure for an electronic device configured as described above, preferably, the chip holding portion has a portion thereof making contact with the heat dissipating sheet formed as a multiply round-ridged contact portion that protrudes in a multiply round-ridged shape. With this configuration, by bringing the multiply round-ridged contact portion into contact with the heat generating part of the IC chip, it is possible to reliably dissipate the heat of the IC chip via the heat dissipating sheet interposed, and it is thus possible to achieve sufficient heat dissipation and improve the reliability of the electronic device.

According to the invention, in the heat dissipation structure for an electronic device configured as described above, preferably, the chip holding portion has a portion thereof making contact with the heat dissipating sheet formed as a spherical contact portion that protrudes in a spherical shape. With this configuration, by bringing the spherical contact portion into contact with the heat generating part of the IC chip, it is possible to reliably dissipate the heat of the IC chip via the heat dissipating sheet interposed, and it is thus possible to achieve sufficient heat dissipation and improve the reliability of the electronic device.

According to the invention, in the heat dissipation structure for an electronic device configured as described above, preferably, the chip holding portion is fitted with a heat pipe which makes contact with the heat dissipating sheet to cool the heat dissipating sheet. With this configuration, it is possible to effectively promote heat transfer via the heat pipe, and thereby to achieve sufficient heat dissipation and improve the reliability of the electronic device.

According to the invention, in the heat dissipation structure for an electronic device configured as described above, preferably, the chip holding portion has a thinner portion formed in the bent portion thereof so as to be easily elastically deformable. With this configuration, the bent portion of the chip holding portion can be displaced easily; this prevents too high pressure, and allows the heat dissipating sheet to be pressed evenly over its entire area; it is thus possible to achieve sufficient heat dissipation and improve the reliability of the electronic device.

According to the invention, in the heat dissipation structure for an electronic device configured as described above, preferably, in the cover member, a first pressing force adjustment screw which presses the chip holding portion against the heat dissipating sheet is provided so that, via the first pressing force adjustment screw, the pressing force with which the chip holding portion is pressed against the heat dissipating sheet can be adjusted. With this configuration, via the first pressing force adjustment screw, the pressing force with which the heat dissipating sheet is pressed against the IC chip can be adjusted; it is thus possible to adjust the pressing force adequately to reliably dissipate the heat of the IC chip; it is thereby possible to achieve sufficient heat dissipation and improve the reliability of the electronic device.

According to the invention, in the heat dissipation structure for an electronic device configured as described above, preferably, the chip holding portion has a tip end portion of the contact section extended and, in the extended portion located beyond the IC chip, a second pressing force adjustment screw which presses the contact section against the heat dissipating sheet is provided so that, via the second pressing force adjustment screw, the pressing force with which the contact section is pressed against the heat dissipating sheet can be adjusted. With this configuration, via the second pressing force adjustment screw, the pressing force with which the heat dissipating sheet is pressed against the IC chip can be adjusted; it is thus possible to adjust the pressing force adequately to reliably dissipate the heat of the IC chip; it is thereby possible to achieve sufficient heat dissipation and improve the reliability of the electronic device.

According to the invention, in the heat dissipation structure for an electronic device configured as described above, preferably, the heat dissipating sheet is arranged over the entire area of the contact section and of the elastic section. With this configuration, attaching the heat dissipating sheet to the chip holding portion having elasticity achieves a vibration damping effect, and it is thus possible to prevent the chip holding portion as a flat spring member from making noise.

According to the invention, in the heat dissipation structure for an electronic device configured as described above, preferably, the chip holding portion has a reinforcement rib formed on the elastic section. With this configuration, it is possible to increase the strength of the chip holding portion as a flat spring member.

According to the invention, in the heat dissipation structure for an electronic device configured as described above, preferably, the chip holding portion has a tip end portion of the contact section extended and, in the extended portion, a grounding member which makes contact with a ground pattern on the board is arranged. With this configuration, it is possible to reduce unwanted radiation from the chip holding portion formed of sheet metal, and thereby to improve the reliability of the electronic device.

According to the invention, in the heat dissipation structure for an electronic device configured as described above, preferably, the chip holding portion has the contact section so sized as to have an enlarged face portion which surrounds the circumference of the IC chip and, in the enlarged face portion, a grounding member which makes contact with a ground pattern on the board is arranged so as to surround the IC chip. With this configuration, it is possible to reduce unwanted radiation from the chip holding portion formed of sheet metal and from the IC chip itself, and thereby to further improve the reliability of the electronic device.

According to the invention, in the heat dissipation structure for an electronic device configured as described above, preferably, the chip holding portion has, provided on the contact section, a shielding rib which covers the side face of the heat dissipating sheet and of the side face of the IC chip. With this configuration, it is possible to reduce unwanted radiation from the IC chip itself, and thereby to improve the reliability of the electronic device.

According to the invention, in the heat dissipation structure for an electronic device configured as described above, preferably, the IC chip includes an electrode terminal on the side face thereof, the heat dissipating sheet is extended to the electrode terminal, and a terminal pressing piece which presses the heat dissipating sheet against the electrode terminal is provided on the chip holding portion. With this configuration, it is possible to promote heat dissipation from the electrode terminal portion of the IC chip to reliably dissipate the heat of the IC chip; it is thereby possible to achieve sufficient heat dissipation and improve the reliability of the electronic device.

According to the invention, in the heat dissipation structure for an electronic device configured as described above, preferably, the corner portion of the heat dissipating sheet is cut in a tapered shape or is rounded in an arc shape. With this configuration, rounding the corner portion of the top face of the heat dissipating sheet attached to the IC chip gives it a shape that is unlikely to drop off during assembly; it is thus possible to reliably attach the heat dissipating sheet to IC chip.

### Advantageous Effects of the Invention

According to the present invention, in a heat dissipation structure where an IC chip as a heat generating body is mounted on a board and a heat dissipating sheet is interposed between the IC chip and a cover member, the heat dissipating sheet is pressed against the IC chip via a chip holding portion, and the chip holding portion is an elastic holding portion provided with an elastic section which is elastically deformable and a contact section which makes contact with the heat dissipating sheet. Thus, even when variation occurs in the distance between the IC chip and the cover member, it is possible to bring the IC chip and the heat dissipating sheet, and the heat dissipating sheet and the cover member, into contact with each other under adequate pressure; it is thus possible to obtain a heat dissipation structure for an electronic device that offers sufficient heat dissipation and can improve the reliability of the electronic device.

### Brief Description of Drawings

Fig. 1A is a schematic side view showing an outline of a heat dissipation structure for an electronic device according to the invention;
Fig. 1B is a schematic plan view showing an outline of a heat dissipation structure for an electronic device according to the invention;
Fig. 2A is a schematic explanatory diagram showing an example of the configuration of a chip holding portion according to the invention, showing an example where a contact section has a flat contact portion;
Fig. 2B is a schematic explanatory diagram showing an example of the configuration of a chip holding portion provided with an open window through which a heat dissipating sheet can be checked;
Fig. 2C is a schematic explanatory diagram showing an example of the configuration of a chip holding portion whose contact portion is a round-ridged contact portion;
Fig. 2D is a schematic explanatory diagram showing an example of the configuration of a chip holding portion whose contact portion is a sharp-ridged contact portion;
Fig. 2E is a schematic explanatory diagram showing an example of the configuration of a chip holding portion whose contact portion is a spherical contact portion;
Fig. 2F is a schematic explanatory diagram showing an example of the configuration of a chip holding portion whose entire contact section is a spherical contact portion;
Fig. 3A is a schematic explanatory diagram showing an example where a cover member is provided with a heat dissipating plate, showing an example where a fin-shaped heat dissipating plate is provided on the top face of the cover member;
Fig. 3B is a schematic explanatory diagram showing an example where a rib-shaped heat dissipating plate is provided on the top face of the cover member;
Fig. 4A is a sectional view showing an example of another configuration of a heat dissipating plate, showing a heat dissipating plate provided with a main plate portion and a side plate portion;
Fig. 4B is a sectional view showing an example of a configuration where a heat dissipating piece is provided on an elastic section of a chip holding portion;
Fig. 4C is a sectional view showing an example of a configuration where a heat dissipating piece is provided on a contact section of a chip holding portion;
Fig. 5 is a schematic sectional view showing a first modified example provided with a board support portion that holds the board from opposite sides;
Fig. 6 is a schematic sectional view showing a second modified example provided with a board support portion that holds the board from opposite sides;
Fig. 7A is a schematic explanatory diagram showing an example of another configuration of a chip holding portion, showing an example where a contact portion being a multiply round-ridged contact portion;
Fig. 7B is a schematic explanatory diagram showing an example of configuration where a heat pipe is provided on a contact portion;
Fig. 7C is a schematic explanatory diagram showing an example of a configuration where a thinner portion is provided in a bent portion for easy elastic deformation;
Fig. 8A is a schematic explanatory diagram showing an example of another configuration of a chip holding portion, showing an example where a first pressing force adjustment screw is provided;
Fig. 8B is a schematic explanatory diagram showing an example of a configuration where a second pressing force adjustment screw is provided;
Fig. 8C is a schematic explanatory diagram showing an example of a configuration where a heat dissipating sheet is arranged over the entire surface of an elastic section and of a contact section;
Fig. 9A is a schematic explanatory diagram showing an example of another configuration of a chip holding portion, showing an example where a reinforcement rib is provided on an elastic section;
Fig. 9B is a schematic explanatory diagram showing an example of a configuration where a reinforcement rib is provided on a side portion of an elastic section;
Fig. 9C is a schematic explanatory diagram showing an example of a configuration where a terminal pressing piece is provided which presses a heat dissipating sheet against an electrode terminal portion provided on an IC chip;
Fig. 10A is a schematic explanatory diagram showing another modified example of a chip holding portion, showing an example where an on-board contact as a grounding member is provided on an extended portion;
Fig. 10B is a schematic explanatory diagram showing a modified example where a gasket as a grounding member is provided on an extended portion;
Fig. 10C is a schematic explanatory diagram showing a modified example where a gasket is provided so as to surround the circumference of an IC chip; and
Fig. 10D is a schematic explanatory diagram showing a modified example where a side portion of a contact section is bent to form a shielding member for an IC chip.

### Description of Embodiments

Embodiments of the present invention will be described below with reference to the accompanying drawings. The same parts are identified by the same reference signs throughout, and no overlapping description will be repeated unless necessary.

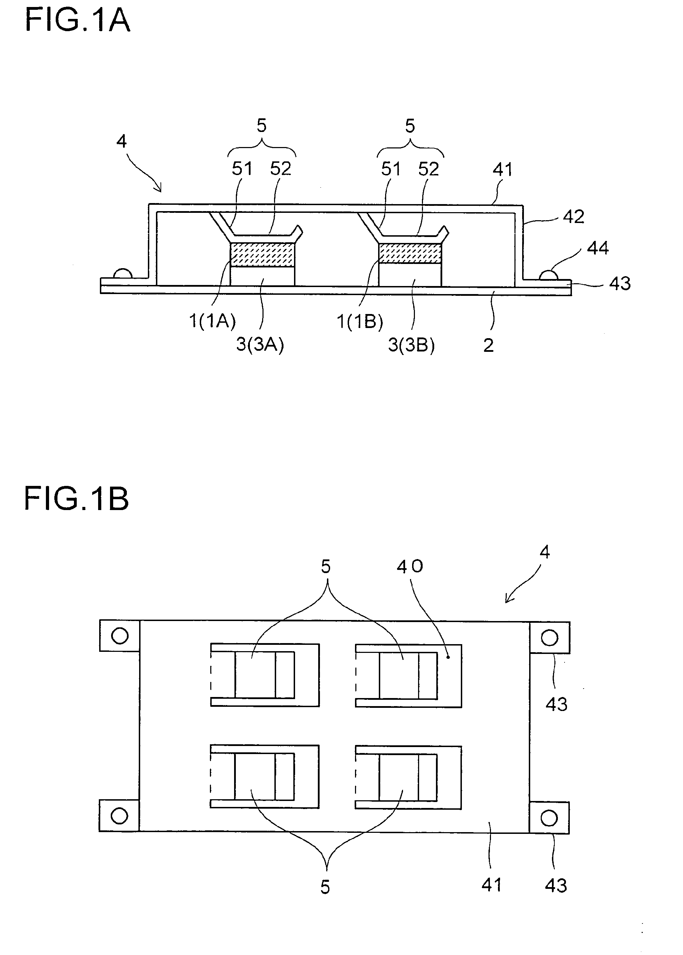

A heat dissipation structure for an electronic device according to an embodiment of the invention is a heat dissipation structure directed to an electronic device provided with a board on which electronic components, such as IC chips (semiconductor chips), are mounted. It is, for example, a heat dissipation structure as shown in Fig. 1A that achieves heat dissipation by interposing a heat dissipating sheet 1 (1A, 1B) between an IC chip 3 (3A, 3B) mounted on a board 2 and a cover member 4, such as a board cover, covering the mounting face side of the board 2.

Preferable as this heat dissipating sheet is a rubber sheet that has such flexibility as to be easily deformable in the thickness direction and that has such hardness as to be easily pressed against and brought into reliable contact with the IC chip 3 irrespective of variation in the distance between the IC chip 3 and the cover member 4. For example, it is possible to use a rubber sheet having a heat dissipating property, such as a silicone rubber sheet or an acrylic rubber sheet, with an Asker C hardness of about 10 to 60. The Asker C hardness is a measure of rubber hardness defined in the standard formulated by the Society of Rubber Science And Technology, Japan, and corresponds to the Shore E hardness defined in JIS (Japanese Industrial Standards) K 6253.

The cover member 4 is a board cover having a top face 41, a side face 42, and a fitting face 43. It is formed by bending sheet metal, such as of aluminum, that has a heat conducting property and offers heat dissipation, and is fixed, with its fitting face 43 placed on the board 2, using fastening screws 44. In a case where a plurality of IC chips 3 (3A, 3B) are mounted on the board 2, chip holding portions 5 are provided at positions on the top face corresponding to where those IC chips are mounted.

As shown in Fig. 1 B, for example, in a configuration where four IC chips 3 are mounted on a rectangular board 2, the cover member 4 is formed to be rectangular as seen in a plan view. To match the number of IC chips 3 mounted, four chip holding portions 5 are provided on the cover member 4 which is rectangular as seen in a plan view. It is preferable that the chip holding portions 5, too, be made of sheet metal that has a heat conducting property, and these can be formed through sheet metal working of the top face 41 of the cover member 4 which has a heat conducting property. Instead, holding portions as separate members that have a heat conducting property may be joined to the cover member 4.

Forming the chip holding portions 5 through sheet metal working of the cover member 4 has the advantage of facilitating the formation of the chip holding portions 5. Forming the chip holding portions 5 as separate members has the advantage of facilitating the selection of a material having the desired heat conducting property for the chip holding portions 5.

It is preferable that each chip holding portion 5 have such a protrusion height as to allow the heat dissipating sheet 1 to be interposed in a pressed state between the corresponding IC chip 3 and cover member 4. Using as the heat dissipating sheet 1 a flexible sheet with a prominent heat dissipating property, such as of silicone rubber or acrylic rubber, has the advantage of facilitating the elastic pressing of the heat dissipating sheet 1 into pressed contact via the chip holding portion 5.

To bring the IC chip 3 and the heat dissipating sheet 1, and the heat dissipating sheet 1 and the cover member 4, into contact with each other even when variation occurs in the distance between the IC chip 3 and the cover member 4, and thereby to obtain sufficient heat dissipation and improve the reliability of the electronic device, it is preferable that the chip holding portion 5 be an elastic holding portion that has elasticity in the thickness direction of the heat dissipating sheet 1.

Accordingly, in this embodiment, the chip holding portion 5 is an elastic holding portion provided with an elastic section 51 which is at one end secured to the cover member 4 so as to be elastically deformable in the direction away from the cover member and a contact section 52 which connects to the other end of the elastic section and makes contact with the heat dissipating sheet 1.

With the configuration described above, where the heat dissipating sheet 1 is flexible and in addition the chip holding portion 5 which presses the heat dissipating sheet 1 against the IC chip 3 has elasticity, even when variation occurs in the distance between the IC chip 3 and the cover member 4, it is possible to bring the IC chip 3 and the heat dissipating sheet 1, and the heat dissipating sheet 1 and the cover member 4, into contact with each other under adequate pressure. Thus, according to this embodiment, the heat of the IC chip 3 quickly conducts from the heat dissipating sheet 1 having a heat conducting property via the chip holding portion 5 to the cover member 4 serving as a heat dissipating plate; it is thus possible to quickly dissipate the heat of the IC chip 3.

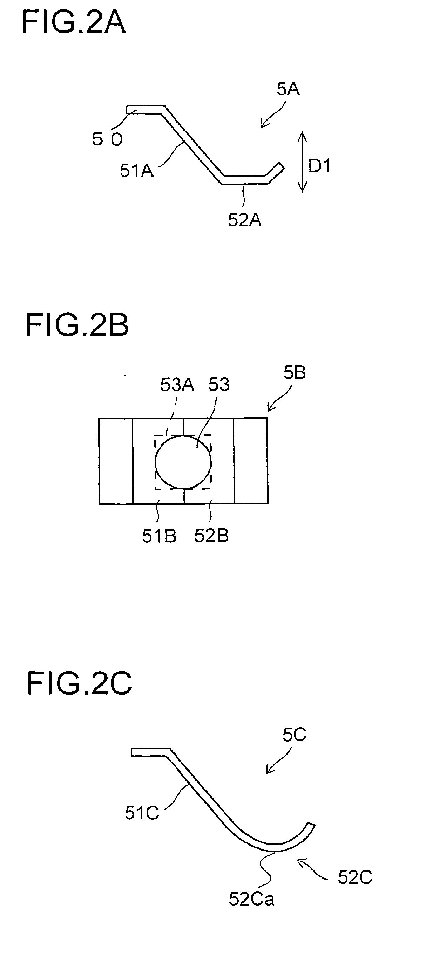

Next, preferred shapes and configurations of the chip holding portion 5 will be described with reference to Figs. 2A to 2F.

Fig. 2A shows a chip holding portion 5A having a rectangular elastic section 51 A and a rectangular contact section 52A. The chip holding portion 5A may be formed through sheet metal working of the top face of the cover member 4, or may be formed of sheet metal as a separate member having a heat conducting property (as of a high tensile steel plate, copper plate, or aluminum alloy plate). When formed as a separate member, the chip holding portion 5A is provided with a fitting section 50, which is joined to the cover member 4.

In a case where the chip holding portion 5 (5A) as a separate member is provided on the cover member 4, no opening needs to be formed in the cover member 4; even then it is preferable to form an opening beforehand in the part where a chip holding portion will be provided so that there a chip holding portion 5 as a separate member is fitted accurately at the desired position. In particular, in a case where an open window through which to visually check the heat dissipating sheet is provided in the chip holding portion, it is preferable to form an opening 40 (see Fig. 1B) beforehand in the part where a chip holding portion 5 will be provided.

Owing to the chip holding portion 5A having the elastic section 51A and the contact section 52A, the elasticity of the elastic section 51A permits the contact section 52A to deform freely in the direction in which it makes contact with the IC chip (in the figure, the direction indicated by arrow D1). Thus, even when variation occurs in the distance between the IC chip and the cover member, it is possible to bring the IC chip and the heat dissipating sheet, and the heat dissipating sheet and the cover member, into contact with each other under adequate pressure; it is thus possible to achieve sufficient heat dissipation and improve the reliability of the electronic device.

Fig. 2B shows a chip holding portion 5B having an open window through which whether the heat dissipating sheet and the IC chip are present or absent can be checked. There is no particular restriction on the shape of the open window, which may be, for example, an open window 53 with a round hole, or an open window 53A with a rectangular hole. With this configuration, it is possible to check whether or not the heat dissipating sheet is actually interposed; it is thus possible to prevent failure to fit it, and thereby to obtain a heat dissipation structure for an electronic device that reliably offers the desired heat dissipating effect.

For reliable conduction and dissipation of the heat generated by the IC chip, it is preferable that the open window 53 or 53A be provided at a position away from right over the heat-generating part of the IC chip. Accordingly, in this embodiment, as shown in the figure, it is provided at a position away from the center of the contact section 52B, at its boundary with the elastic section 51B.

Also with this configuration, it is easy to visually check the heat dissipating sheet, and thus it is possible to reliably prevent failure to fit it. The open window 53 or 53A may be a small window, and may be provided in a central part of the contact section 52B so long as it is so sized as not to adversely affect heat conductivity.

The contact section may have any shape other than that of the contact section 52A having a flat contact portion which makes plane contact. For example, as shown in Fig. 2C, a chip holding portion 5C may be provided with an elastic section 51C and a contact section 52C having a round-ridged contact portion that protrudes in a round-ridged shape (with a D-shaped cross section). With this configuration, by bringing the round-ridged contact portion 52Ca into line contact with the heat generating part of the IC chip, it is possible to reliably bring the heat dissipating sheet into contact with the heat generating part of the IC chip, and thereby to obtain a heat dissipation structure for an electronic device that reliably offers the desired heat dissipating effect.

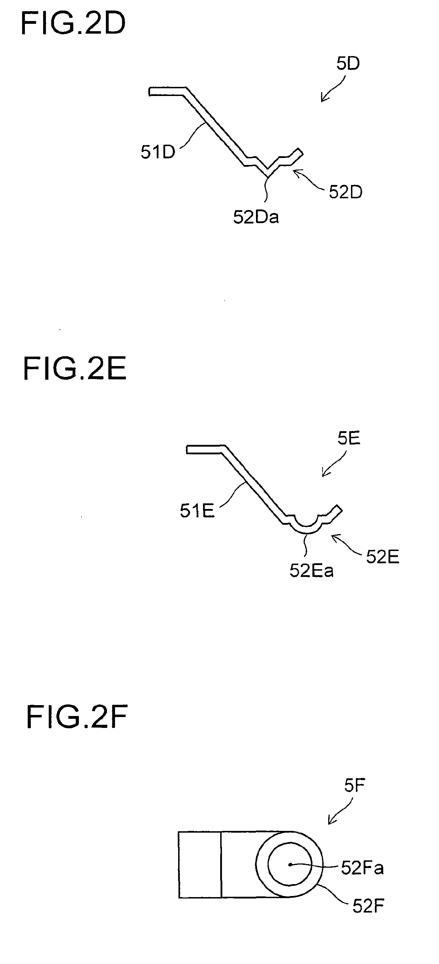

The chip holding portion 5D shown in Fig. 2D is provided with an elastic section 51D and a contact section 52D having a sharp-ridged contact portion that protrudes in an sharp-ridged shape. Also with this configuration, by bringing the sharp-ridged contact portion 52Da into line contact with the heat generating part of the IC chip, it is possible to obtain a heat dissipation structure for an electronic device that reliably offers the desire heat dissipating effect.

The chip holding portion 5E shown in Fig. 2E is provided with an elastic section 51E and a contact section 52E having a spherical contact portion that protrudes in a spherical shape. As shown in Fig. 2F, a chip holding portion 5F may be provided with a spherical contact section 52F of which the entirety protrudes in a spherical shape. The black dot 52Fa at the center shown in the figure indicates the spherical contact portion which makes point contact.

With a configuration where a spherical contact portion 52Ea or 52Fa is brought into contact with the heat generating part of the IC chip, it is possible to reliably bring the round tip part into point contact with the heat generating part, and also to adjust the contact pressure easily; it is thus possible to obtain a heat dissipation structure for an electronic device that reliably offers the desired heat dissipating effect.

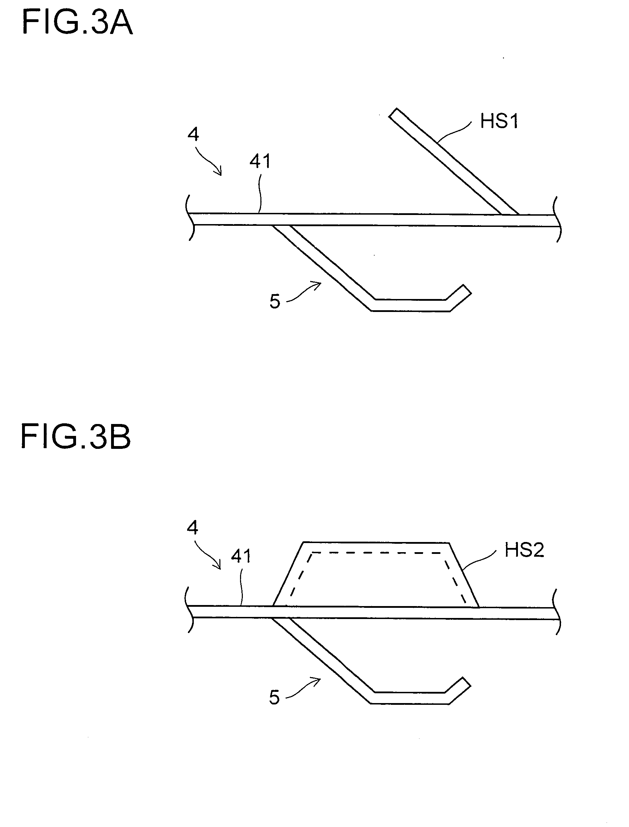

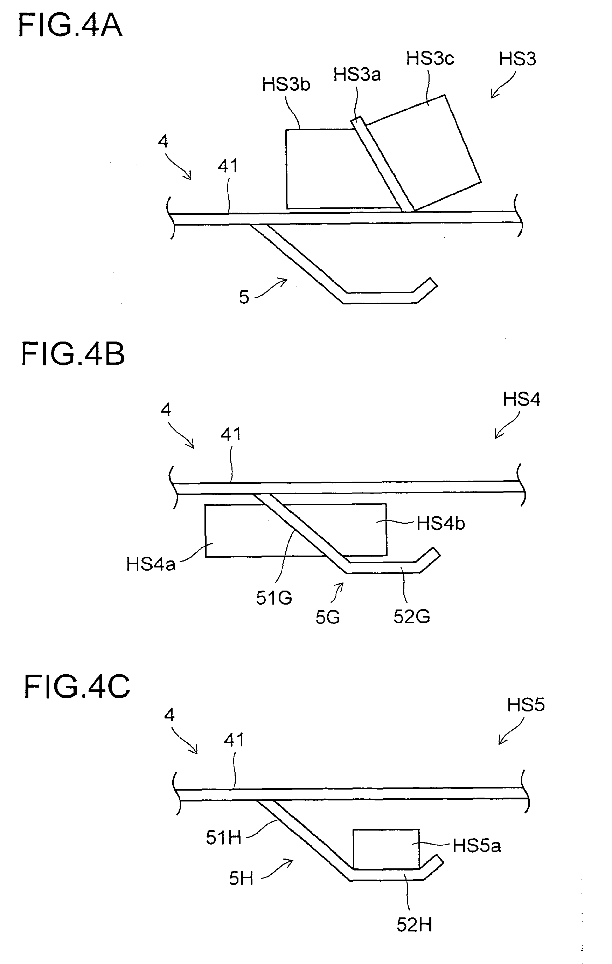

By, in addition to transferring heat via the heat dissipating sheet and the chip holding portion to the cover member, providing a fin-shaped or rib-shaped heat dissipating plate, it is possible to further enhance heat dissipation. In this connection, with reference to Figs. 3A, 3B, and 4A to 4C, a description will be given of embodiments in which a heat dissipating plate is provided.

Fig. 3A shows an example where a fin-shaped heat dissipating plate HS1 is provided on the top face 41 of the cover member 4. The heat dissipating plate HS1 is provided as a protruding plate provided on the outer side of the cover member 4 opposite from the side where the chip holding portion 5 is provided. With this configuration, it is possible to further improve heat dissipation, and thereby to achieve more sufficient heat dissipation and improve the reliability of the electronic device.

The heat dissipating plate HS1 may be formed by cutting out part of the cover member, or maybe provided by attaching a heat dissipating plate as a separate member to the cover member 4. In a case where it is formed by cutting out part of the cover member, the chip holding portion 5 is formed as a separate member. In a case where the chip holding portion 5 is formed by cutting out part of the cover member, the heat dissipating plate HS1 is formed as a separate member. These two may both be formed as separate members, in which case an opening is formed in the part of the cover member where the chip holding portion 5 is arranged, and the two are both arranged around the opening.

In a case where a heat dissipating plate as a separate member is provided, irrespective of the material of the cover member, a material having a prominent heat dissipating property can be selected. Instead of the above-described fin-shaped (plate-shaped) heat dissipating plate HS1, a rib-shaped heat dissipating plate HS2 as shown in Fig. 3B that protrudes in the shape of a box may be provided. Any shape other than plate-like and box-like shapes may be adopted, and it is possible to provide a heat dissipating plate having a sufficient heat dissipation area to offer the desired heat dissipation.

For example, as shown in Fig. 4A, a heat dissipating plate HS3 may be one in which a main plate portion HS3 a protruding from the top face 41 of the cover member 4 is provided with a side plate portion HS3b or HS3c. The heat dissipating plate may be provided around the chip holding portion. For example, as shown in Fig. 4B, a heat dissipating plate HS4 provided with a heat dissipating plate HS4a or HS4b may be provided on an elastic section 5 1 G of a chip holding portion 51; or as shown in Fig. 4C, a heat dissipating plate HS5 may be one in which a heat dissipating plate HS5a is provided on a contact section 52H of a chip holding portion 5H.

In a case where a heat dissipating plate is provided on a chip holding portion, needless to say, the heat dissipating plate needs to be so sized and so located as not to hamper the elastic deformation of the chip holding portion in its movement region in which it presses the heat dissipating sheet against the IC chip.

By, as described above, providing a heat dissipating plates HS (HS 1 to HS5) of any of various shapes in a predetermined part of the cover member 4 or the chip holding portion 5 to allow heat to be transferred via the heat dissipating sheet 1 attached to the heat generating IC chip 3 and the chip holding portion 5 making contact with the heat dissipating sheet 1 to the cover member 4, it is possible to achieve quick heat dissipation.

In particular, in a case where the heat dissipating plate HS and the chip holding portion 5 are both configured as separate members from the cover member 4, by use of the heat dissipating plate HS formed as a member having a prominent heat dissipating property and the chip holding portion 5 formed as a member having prominent elasticity, it is possible to reliably interpose the heat dissipating sheet 1 between the IC chip 3 and the cover member 4 and thereby to achieve the desired heat dissipation effect.

Moreover, by giving the contact portion of the chip holding portion 5 which makes contact with the heat dissipating sheet 1 a shape that makes line contact or point contact, like a round-ridged contact portion 52Ca, a sharp-ridged contact portion 52Da, or a spherical contact portion 52Ea, and thereby reliably bringing it into contact with the predetermined part of the heat dissipating sheet 1 corresponding to the heat generating part of the IC chip 3, it is possible to improve the heat dissipation of the IC chip 3.

This is because the heat dissipation by an IC chip is generally highest in a central part of the IC chip, which thus acts as the heat generating part, and therefore enhancing the heat dissipation from the heat generating part is most effective in dissipating heat from the IC chip. Accordingly, it is preferable that the contact portion of the chip holding portion 5 be provided at the position where the heat dissipating sheet is pressed against the heat generating part.

By, as described above, forming the chip holding portion provided on the cover member as an elastic holding portion, and providing a heat dissipating plate on the cover member or the chip holding portion, it is possible to obtain a heat dissipation structure for an electronic device that offers sufficient heat dissipation and improves the reliability of the electronic device. Furthermore, by giving the contact portion of the chip holding portion a shape that makes line contact or point contact, and thereby adopting a configuration that achieves reliable contact with the heat generating part, it is possible to further improve heat dissipation.

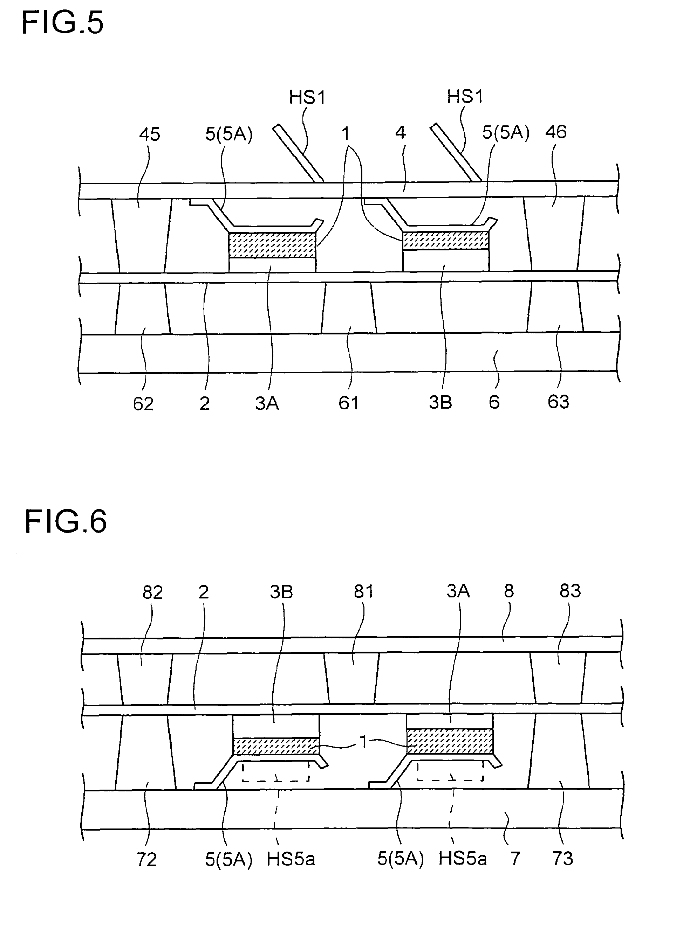

Moreover, by exploiting a configuration in which the cover member 4 and the base member support the board by holding it from opposite sides, it is possible to suppress deformation in the board and obtain good contact between the heat dissipating sheet and the IC chip so as to achieve sufficient heat dissipation. Corresponding embodiments will now be described by way of a first modified example shown in Fig. 5 and a second modified example shown in Fig. 6.

In the first modified example shown in Fig. 5, board support legs 62 and 63 provided on a base member 6 and board support legs 45 and 46 provided on a cover member 4 hold a board 2 from opposite sides. Moreover, on the base member 6, a middle portion support leg 61 is provided which supports between IC chips 3A and 3B. With this configuration, it is possible to suppress deformation of the board 2, and thus advantageously it is possible to obtain a configuration where even when the heat dissipating sheet 1 and the IC chips are brought into pressed contact with each other, the board 2 does not yield or deform and thus does not suffer damage.

Also with the configuration described above, by adopting a configuration where the heat dissipating sheet laid on the IC chips 3A and 3B is brought into pressed contact via the chip holding portion 5 (5A) provided on the cover member 4, it is possible to bring the IC chips 3A and 3B and the heat dissipating sheet 1, and the heat dissipating sheet 1 and the cover member 4, into contact with each other, and thereby to obtain a heat dissipation structure for an electronic device that offers sufficient heat dissipation and can improve the reliability of the electronic device. By providing a heat dissipating plate HS1 on the cover member 4, it is possible to further improve heat dissipation.

In the second modified example shown in Fig. 6, a configuration is adopted where, when a board 2 is supported with the mounting face pointing down, by use of a lower base member 7 and an upper base member 8, the board 2 is held in position between board support legs 72 and 73 provided on the lower base member 7 and board support legs 82 and 83 provided on the upper base member 8. Moreover, on the upper base member 8, a middle portion support leg 81 is provided which supports between the IC chips 3A and 3B.

Also with this configuration, it is possible to obtain a configuration that can suppress yielding and deformation of the board 2. Thus, it is possible to obtain a configuration where, even when the heat dissipating sheet 1 and IC chips are brought in pressed contact, the board does not suffer damage.

Moreover, by adopting a configuration where the heat dissipating sheet 1 laid on the IC chips 3A and 3B is brought into pressed contact via the chip holding portion 5 (5A) provided on the lower base member 7, it is possible to bring the IC chips 3A and 3B and the heat dissipating sheet 1, and the heat dissipating sheet 1 and the upper base member 8, into contact under adequate pressure, and thereby to obtain a heat dissipation structure for an electronic device that offers sufficient heat dissipation and can improve the reliability of the electronic device. By providing, for example, the above-described heat dissipating section HS5a on the chip holding portion 5 (5A), it is possible to further improve heat dissipation.

With a configuration, like those of the first modified example shown in Fig. 5 and the second modified example shown in Fig. 6, where board support portions (corresponding to the board support legs mentioned above) for holding the board 2 from opposite sides are provided, it is possible to obtain a configuration that can suppress yielding and deformation of the board 2, and thus it is possible to attach the heat dissipating sheet 1 to the IC chip 3 (3A, 3B) in pressed contact with it without damaging the board 2.

When the heat dissipating sheet 1 is attached to the IC chip 3 (3A, 3B), it is preferable that the corner portion of the heat dissipating sheet 1 be cut in a tapered shape, or be rounded into an arc shape. With this configuration, rounding the corner portion of the heat dissipating sheet 1 attached to the IC chip 3 (3A, 3B) gives it a shape that is unlikely to drop off during assembly. This makes it possible to reliably attach the heat dissipating sheet 1 to the IC chip 3 (3A, 3B).

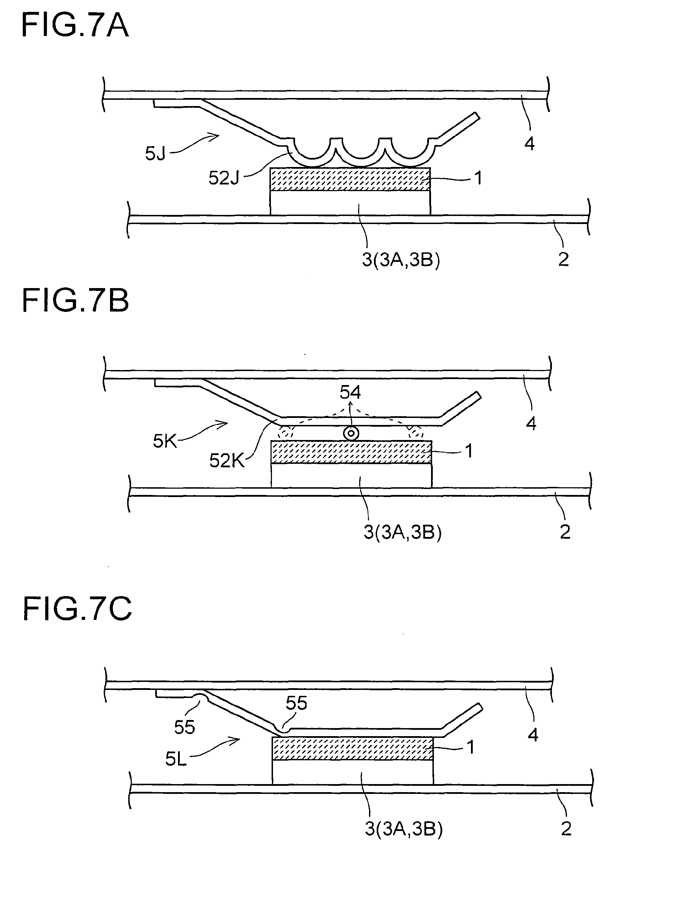

Now, a description will be given of other ingenious designs for achieving heat dissipation by pressing the heat dissipating sheet against the IC chip via the chip holding portion with reference to Figs. 7A to 10D.

Fig. 7A shows a chip holding portion 5J provided with a multiply round-ridged contact portion 52J that protrudes in a multiply round-ridged shape. With this configuration, by bringing the multiply round-ridged contact portion 52J into contact with the heat generating part of the IC chip 3 (3A, 3B), it is possible to reliably dissipate the heat of the IC chip 3 via the heat dissipating sheet 1 interposed; it is thus possible to achieve sufficient heat dissipation and improve the reliability of the electronic device.

Even with a contact section having a flat contact face as shown in Fig. 7B, by providing the chip holding portion 5K with a heat pipe 54 that makes contact with the heat dissipating sheet 1 to cool it, it is possible to further effectively promote heat transfer, and it is thereby possible to achieve sufficient heat dissipation and improve the reliability of the electronic device.

This is because the heat pipe 54 is filled with an operating fluid which mediates heat transfer and the operating fluid, by moving between a heat entry portion which is a high temperature portion and a heat dissipation portion which is a low temperature portion, quickly exerts a cooling effect. There may be provided one heat pipe or a plurality of heat pipes, an adequate number of heat pipes may be provided depending on the size of the heat generating part of the IC chip 3 and the degree to which it generates heat.

It is preferable that the chip holding portion be easily elastically deformable; accordingly, for example, as shown in Fig. 7C, a chip holding portion 5L may be provided with a thinner portion 55 in the bent portion. With this configuration, the bent portion of the chip holding portion 5L easily deforms; it is thus possible to prevent too hard pressing and to allow the heat dissipating sheet 1 to be pressed evenly over its entire area; it is thereby possible to achieve sufficient heat dissipation and improve the reliability of the electronic device.

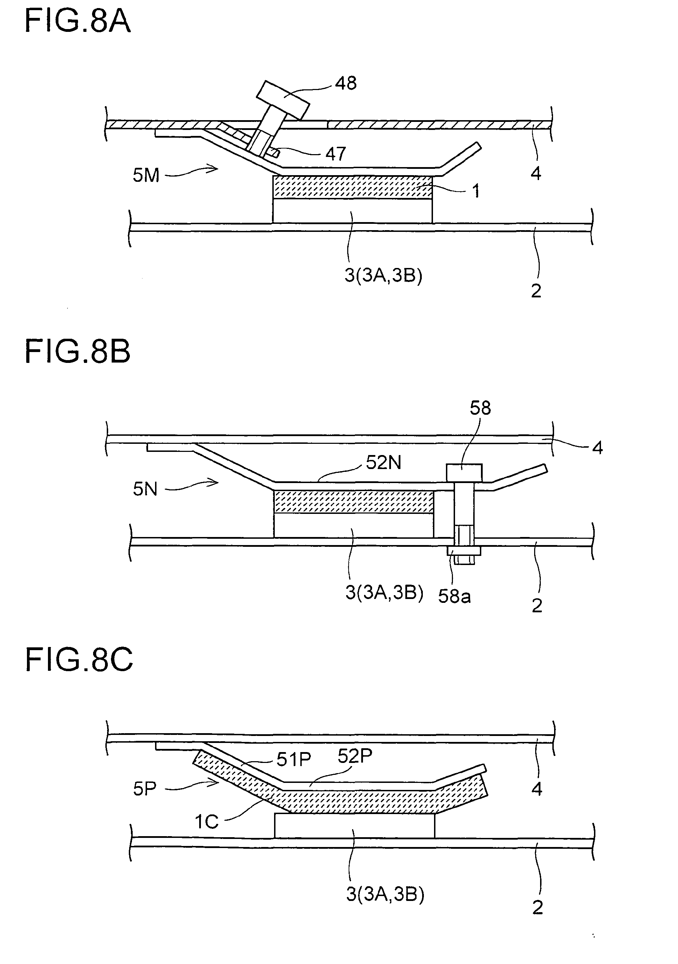

It is possible to adopt a configuration where, in addition to the elastic force of the chip holding portion itself, a predetermined pressing force is applied from outside. For example, as shown in Fig. 8A, a first pressing force adjustment screw 48 may be provided which presses the chip holding portion 5M against the heat dissipating sheet 1; as shown in Fig. 8B, the tip end part of the contact section 52N may be extended so that, in its extended portion located beyond the IC chip, a second pressing force adjustment screw 58 is provided which presses the contact section 52N against the heat dissipating sheet 1.

With a chip holding portion 5M so configured as to apply a predetermined pressing force by use of a first pressing force adjustment screw 48 attached to a screw fitting portion 47 provided on the cover member 4, it is possible, via this first pressing force adjustment screw 48, to adjust the pressing force with which the heat dissipating sheet 1 is pressed against the IC chip 3 (3A, 3B); thus, it is possible to adjust the pressing force adequately to reliably dissipate the heat of the IC chip 3, and it is thereby possible to achieve sufficient heat dissipation and improve the reliability of the electronic device.

On the other hand, with a chip holding portion 5N so configured as to apply a predetermined pressing force by use of a second pressing force adjustment screw 58 that is so attached as to couple the extended portion formed by extending the tip end portion of the contact section 52N with the board 2 and that is fastened with a nut 58a, it is possible, via this second pressing force adjustment screw 58, to adjust the pressing force with which the heat dissipating sheet 1 is pressed against the IC chip 3 (3A, 3B); thus, it is possible to adjust the pressing force adequately to reliably dissipate the heat of the IC chip 3, and it is thereby possible to achieve sufficient heat dissipation and improve the reliability of the electronic device.

It is possible to adopt a configuration where a first pressing force adjustment screw 48 and a second pressing force adjustment screw 58 are used together to adjust the contact force between the heat dissipating sheet and the IC chip. Any of these configurations is preferable because they all allow application of an adequate pressing force irrespective of the elastic force of the chip holding portion itself.

As a result of the chip holding portion as a flat spring being pressed against the IC chip, depending on the force with which and the manner in which it is pressed, vibration may cause noise. To prevent that, as shown in Fig. 8C, a chip holding portion 5P may be configured such that the heat dissipating sheet 1C is arranged over the entire surface of the elastic section 51P and of the contact section 52P. With this configuration, attaching the heat dissipating sheet 1C to the elastic chip holding portion 5P having elasticity achieves a vibration damping effect, and it is thereby possible to prevent the chip holding portion 5P as a flat spring from making noise.

Also with the chip holding portion configured as described above, the first pressing force adjustment screw 48 or the second pressing force adjustment screw 58 described previously or the like may be attached to it to allow adjustment of the pressing force.

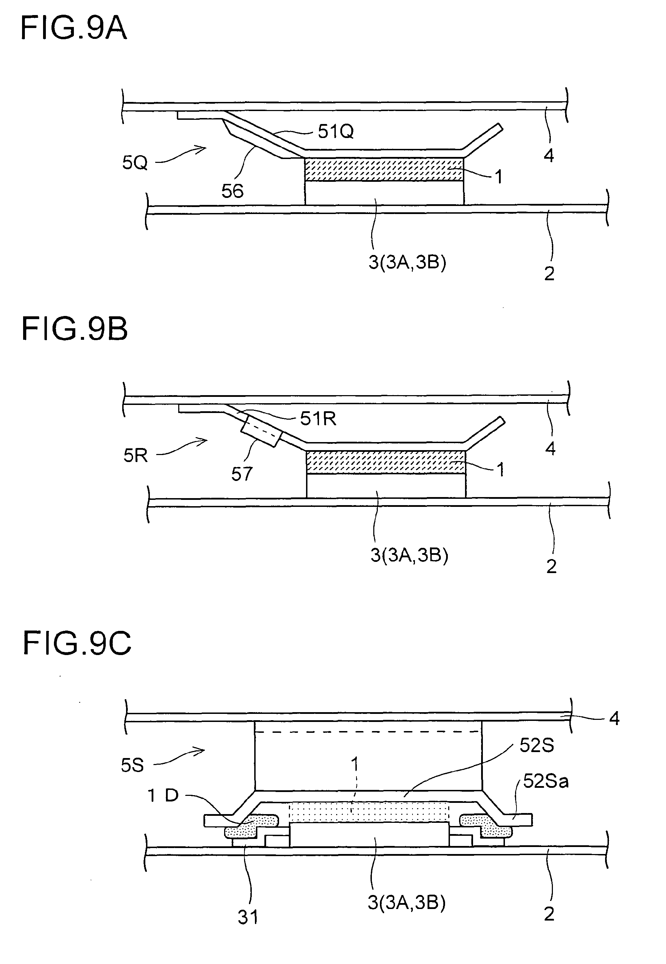

To increase the strength of the chip holding portion, a reinforcement rib is provided in a predetermined part of its sheet metal structure. For example, as shown in Fig. 9A, a chip holding portion 5Q is provided with a reinforcement rib 56 on the rectangular face of the elastic section 51Q. Instead, as shown in Fig. 9B, a chip holding portion 5R is so configured as to be provided with a reinforcement rib 57 by bending at least one side face, or both side faces, of the elastic section 51 R. With this configuration, it is possible to increase the strength of the elastic section 51 Q or 51 R as a flat spring member.

In a case where not only the main part of the IC chip 3 (3A, 3B) generates heat but also the electrode terminals provided on the side face of the IC chip body generate large amounts of heat, as shown in Fig. 9C, it is possible to achieve enhanced heat dissipation by use of a chip holding portion 5S provided with a terminal pressing piece 52Sa which presses the heat dissipating sheet 1D. The heat dissipating sheet 1D may be formed by extending the heat dissipating sheet 1, or may be a heat dissipating sheet separate from the heat dissipating sheet 1. To suppress the number of components, however, it is preferable to extend the heat dissipating sheet 1 so that a single component will do.

As described above, with a configuration where the heat dissipating sheet is extended to the electrode terminal portion 31 and the chip holding portion 5S is provided with a terminal pressing piece 52Sa which presses the heat dissipating sheet 1D against the electrode terminal portion 31, it is possible to promote heat dissipation from the electrode terminal portion of the IC chip 3 and to reliably dissipate the heat of the IC chip 3; it is thus possible to achieve sufficient heat dissipation and improve the reliability of the electronic device.

Reducing unwanted radiation from the chip holding portion and from the IC chip is preferable to improve the reliability of the electronic device, and therefore a description will be given of configurations that reduce unwanted radiation.

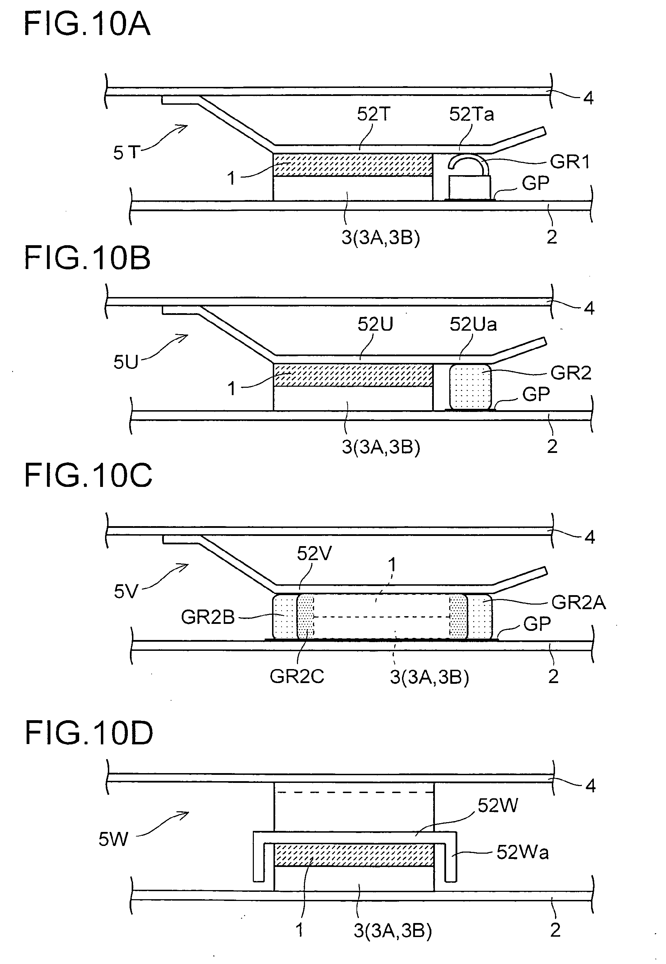

For example, as shown in Fig. 10A, the tip end portion of the contact section 52T of a chip holding portion 5T is extended, and on this extended portion 52Ta, a grounding member GR1 is arranged which makes contact with a ground pattern GP provided on the board 2. With this configuration, it is possible to reduce unwanted radiation from the chip holding portion 5T which is formed of sheet metal, and thereby to obtain a configuration that is not influenced by noise; it is thus possible to improve the reliability of the electronic device.

The grounding member GR1 is grounded to the ground pattern GP provided on the board 2, for example, by use of an on-board contact (manufactured by Kitagawa Industries Co., Ltd.). Instead, as with the chip holding portion 5U shown in Fig. 10B, the chip holding portion 5U is grounded to the ground pattern GP provided on the board 2 by use of a grounding member GR2 such as an electrically conductive gasket.

In the chip holding portion 5V shown in Fig. 10C, its contact section 52V is so sized as to be provided with an enlarged face portion surrounding the circumference of the IC chip 3 (3A, 3B), and on this enlarged face portion, grounding members GR2A, GR2B, and GR2C which make contact with a ground pattern GP provided on the board 2 are arranged so as to surround the IC chip 3. With this configuration, it is possible to reduce unwanted radiation from the chip holding portion 5V which is formed of sheet metal and from the IC chip itself, and thereby to further improve the reliability of the electronic device.

Instead of a grounding member, a shielding member may be used to reduce unwanted radiation from the IC chip 3 (3A, 3B). For example, as in the chip holding portion 5W shown in Fig. 10D, its contact section 52W is provided with a shielding rib 52Wa which covers the side face of the heat dissipating sheet 1 and of the IC chip 3. The shielding rib 52Wa can be formed by bending part of the contact section 52W. Also with this configuration, it is possible, with the shielding rib 52Wa formed of sheet metal, to reduce unwanted radiation from the IC chip 3 itself, and thereby to improve the reliability of the electronic device.

In this way, it is possible to press the heat dissipating sheet 1 against the IC chip 3 via the chip holding portion 5 to achieve heat dissipation, and in addition to reduce unwanted radiation; it is thus possible to further improve the reliability of the electronic device.

As described above, according to the present invention, in a heat dissipation structure where an IC chip as a heat generating body is mounted on a board and a heat dissipating sheet is interposed between the IC chip and a cover member, a chip holding portion which presses the heat dissipating sheet against the IC chip is an elastic holding portion provided with an elastic section which is elastically deformable and a contact section which makes contact with the heat dissipating sheet; thus it elastically deforms according to variation in the distance between the IC chip and the cover member, and brings the IC chip and the heat dissipating sheet, and the heat dissipating sheet and the cover member, into contact with each other under adequate pressure; it is thus possible to obtain a heat dissipation structure for an electronic device that offers sufficient heat dissipation and can improve the reliability of the electronic device.

Moreover, by providing a heat dissipating plate HS of one of various shapes in a part of the cover member or the chip holding portion to allow heat to be transferred via the heat dissipating sheet attached to the heat generating IC chip and the chip holding portion making contact with the heat dissipating sheet to the cover member, it is possible to achieve quick heat dissipation.

Furthermore, cutting the corner portion of the top face of the heat dissipating sheet into a tapered shape or rounding it into an arc shape gives it a shape that is unlikely to drop off during assembly, and it is thus possible to reliably attach the heat dissipating sheet to the IC chip.

### Industrial Applicability

Thus, heat dissipation structures for electronic devices according to the present invention are suitably used in electronic devices in which heat needs to be reliably dissipated from heat-generating IC chips.

### List of Reference Signs

- 1: heat dissipating sheet
- 2: board
- 3: IC chip
- 4: cover member
- 5 (5A-5W): chip holding portion
- 48: first pressing force adjustment screw
- 51: elastic section
- 52: contact section
- 52Ca: round-ridged contact portion
- 52Da: sharp-ridged contact portion
- 52Ea: spherical contact portion
- 52Fa: spherical contact portion
- 53: open window
- 54: heat pipe
- 55: thinner portion
- 56, 57: reinforcement rib
- 58: second pressing force adjustment screw
- HS1-HS5: heat dissipating plate
- GP: ground pattern
- GR1, GR2: grounding member

## Claims

1. A heat dissipation structure for an electronic device, comprising:
an IC chip;
a board on which the IC chip is mounted;
a cover member which has a heat dissipating property and which covers a mounting face side of the board; and
a heat dissipating sheet which is interposed between the IC chip and the cover member, the heat dissipating sheet dissipating heat of the IC chip, wherein
the cover member includes a chip holding portion so that, via the chip holding portion, the heat dissipating sheet is pressed against the IC chip, and
the chip holding portion includes
an elastic section which has one end thereof secured to the cover member so as to be elastically deformable in a direction away from the cover member and
a contact section which is connected to another end of the elastic section and which makes contact with the heat dissipating sheet.

2. The heat dissipation structure for an electronic device according to claim 1, further comprising a heat dissipating plate on an outer side of the cover member opposite from a side thereof on which the chip holding portion is provided.

3. The heat dissipation structure for an electronic device according to claim 2, wherein the chip holding portion is formed by cutting out part of the cover member, and the heat dissipating plate as a separate member is arranged around an opening where the chip holding portion is formed.

4. The heat dissipation structure for an electronic device according to claim 2, wherein the heat dissipating plate is formed by cutting out part of the cover member, and the chip holding portion as a separate member is arranged around an opening where the heat dissipating plate is formed.

5. The heat dissipation structure for an electronic device according to claim 2, wherein the chip holding portion and the heat dissipating plate are both formed as separate members, an opening is formed in a part of the cover member where the chip holding portion is arranged, and the chip holding portion and the heat dissipating plate are both arranged around the opening.

6. The heat dissipation structure for an electronic device according to any one of claims 1 to 5, wherein the chip holding portion has an open window through which whether the heat dissipating sheet is present or absent can be checked.

7. The heat dissipation structure for an electronic device according to any one of claims 1 to 6, wherein the chip holding portion includes a heat dissipating section.

8. The heat dissipation structure for an electronic device according to any one of claims 1 to 7, wherein the chip holding portion has a portion thereof making contact with the heat dissipating sheet formed as a sharp-ridged contact portion that protrudes in a sharp-ridged shape.

9. The heat dissipation structure for an electronic device according to any one of claims 1 to 7, wherein the chip holding portion has a portion thereof making contact with the heat dissipating sheet formed as a round-ridged contact portion that protrudes in a round-ridged shape.

10. The heat dissipation structure for an electronic device according to any one of claims 1 to 7, wherein the chip holding portion has a portion thereof making contact with the heat dissipating sheet formed as a multiply round-ridged contact portion that protrudes in a multiply round-ridged shape.

11. The heat dissipation structure for an electronic device according to any one of claims 1 to 7, wherein the chip holding portion has a portion thereof making contact with the heat dissipating sheet formed as a spherical contact portion that protrudes in a spherical shape.

12. The heat dissipation structure for an electronic device according to any one of claims 1 to 7, wherein the chip holding portion is fitted with a heat pipe which makes contact with the heat dissipating sheet to cool the heat dissipating sheet.

13. The heat dissipation structure for an electronic device according to any one of claims 1 to 12, wherein the chip holding portion has a thinner portion formed in a bent portion thereof so as to be easily elastically deformable.

14. The heat dissipation structure for an electronic device according to any one of claims 1 to 13, wherein, in the cover member, a first pressing force adjustment screw which presses the chip holding portion against the heat dissipating sheet is provided so that, via the first pressing force adjustment screw, a pressing force with which the chip holding portion is pressed against the heat dissipating sheet can be adjusted.

15. The heat dissipation structure for an electronic device according to any one of claims 1 to 14, wherein the chip holding portion has a tip end portion of the contact section extended and, in an extended portion located beyond the IC chip, a second pressing force adjustment screw which presses the contact section against the heat dissipating sheet is provided so that, via the second pressing force adjustment screw, a pressing force with which the contact section is pressed against the heat dissipating sheet can be adjusted.

16. The heat dissipation structure for an electronic device according to any one of claims 1 to 15, wherein the heat dissipating sheet is arranged over an entire area of the contact section and of the elastic section.

17. The heat dissipation structure for an electronic device according to any one of claims 1 to 16, wherein the chip holding portion has a reinforcement rib formed on the elastic section.

18. The heat dissipation structure for an electronic device according to any one of claims 1 to 17, wherein the chip holding portion has a tip end portion of the contact section extended and, in an extended portion, a grounding member which makes contact with a ground pattern on the board is arranged.

19. The heat dissipation structure for an electronic device according to any one of claims 1 to 17, wherein the chip holding portion has the contact section so sized as to have an enlarged face portion which surrounds a circumference of the IC chip and, in the enlarged face portion, a grounding member which makes contact with a ground pattern on the board is arranged so as to surround the IC chip.

20. The heat dissipation structure for an electronic device according to any one of claims 1 to 17, wherein the chip holding portion has, provided on the contact section, a shielding rib which covers a side face of the heat dissipating sheet and of the IC chip.

21. The heat dissipation structure for an electronic device according to any one of claims 1 to 18, wherein the IC chip includes an electrode terminal on a side face thereof, the heat dissipating sheet is extended to the electrode terminal, and a terminal pressing piece which presses the heat dissipating sheet against the electrode terminal is provided on the chip holding portion.

22. The heat dissipation structure for an electronic device according to any one of claims 1 to 21, wherein a corner portion of the heat dissipating sheet is cut in a tapered shape or is rounded in an arc shape.
